# EUROPEAN PATENT SPECIFICATION

(11) **EP 3 189 914 B1**
(45) Date of publication and mention of the grant of the patent: **08.06.2022**
(21) Application number: 15838051.9
(22) Date of filing: 31.08.2015
(51) Int. Cl.: C22C 9/00, H01L 21/52, H05K 3/32, B23K 1/00, B23K 1/008, B23K 1/19, B23K 5/00, B23K 35/30, B23K 35/36, B23K 20/02, B23K 20/16, B23K 20/233, B23K 35/02, H01B 1/22, H01L 23/00, B23K 101/42, B23K 103/12, B22F 9/24, B22F 1/00, B22F 7/06

(54) **BONDING MATERIAL AND BONDING METHOD USING SAME**
BINDEMATERIAL UND BINDERVERFAHREN DAMIT
MATÉRIAU DE COLLAGE ET PROCÉDÉ DE COLLAGE L'UTILISANT

(30) Priority: 01.09.2014 JP 2014176724; 28.08.2015 JP 2015168573
(43) Date of publication of application: 12.07.2017
(73) Proprietor: DOWA Electronics Materials Co., Ltd., Chiyoda-ku Tokyo 101-8617 (JP)
(72) Inventor: ENDOH, Keiichi, Okayama-shi Okayama 702-8053 (JP); MIYOSHI, Hiromasa, Okayama-shi Okayama 700-0962 (JP); MOTOMURA, Kimikazu, Okayama-shi Okayama 701-0204 (JP); KURITA, Satoru, Okayama-shi Okayama 702-8022 (JP)
(74) Representative: Manitz Finsterwald Patent- und Rechtsanwaltspartnerschaft mbB
(86) International application number: PCT/JP2015/004401
(87) International publication number: WO 2016/035314

(56) References cited:
- EP-A1- 2 587 899
- WO-A1-2007/034893
- WO-A1-2013/146504
- WO-A1-2014/080662
- None

## Description

### Technical Field

The present invention relates generally to a bonding material and a bonding method using the same. More specifically, the invention relates to a bonding material of a copper paste containing a copper powder, and a method for bonding articles to each other using the same.

### Background Art

In recent years, it is proposed that a bonding material of a silver paste containing fine silver particles as metal particles is used to be arranged between articles to be heated for a predetermined period of time while applying pressure between the articles, to sinter silver in the bonding material to bond the articles to each other (see, e.g., Document 1).

When such a bonding material is used for fixing an electronic part, such as an Si chip, on a metal substrate, after a silver paste containing fine silver particles dispersed in a solvent is applied on the substrate, the silver paste is heated to remove the solvent to form a pre-dried film on the substrate to arrange the electronic part thereon, and then, the pre-dried film is heated while applying pressure on the electronic part, so that it is possible to bond the electronic part to the substrate via a silver bonding layer.

### Prior Art Document(s)

Document 1: Japanese Patent Laid-Open No. 2011-80147 (Paragraph Numbers 0014-0020);
Document 2: European Patent Application No. 12190163.1 (EP 2 587 899 A1);
Document 3: International Application No. PCT/JP2013/066934 (WO 2014/080662 A1).

### Summary of the Invention

### Problem to be solved by the Invention

However, in the bonding material of Document 1, the fine silver particles are used as metal particles, so that the bonding material is expensive. For that reason, it is desired to provide a bonding material using inexpensive metal particles in comparison with the fine silver particles, for example copper particles, as is disclosed in Documents 2 and 3.

Moreover, when articles are bonded to each other by means of the bonding material, if voids exist on the bonded surfaces thereof, even if the articles are bonded to each other at a desired bonding strength, stress is applied to the portions of the voids when cooling/heating cycles are repeatedly applied thereto. As a result, cracks are formed in the bonding layer from the voids, so that the reliability of bonding is deteriorated. For that reason, in order to satisfactorily bond articles to each other by means of the bonding material, it is required to suppress the generation of voids in the bonded portions, and it is required to suppress the amount of a solvent (dispersing medium) to be added (i.e., to increase the content of metal particles), the solvent causing voids. On the other hand, in order to satisfactorily apply a bonding material by screen printing using a metal mask, it is required to decrease the viscosity of the bonding material. However, if the viscosity of the bonding material is decreased, the content of metal in the bonding material is decreased. On the other hand, if the content of metal in the bonding material is increased, the viscosity of the bonding material is increased. Thus, the relationship between the viscosity of the bonding material and the content of metal in the bonding material is the trade-off relationship.

It is therefore an object of the present invention to eliminate the aforementioned problems and to provide an inexpensive bonding material, which can be easily printed on articles to be bonded to each other and which can suppress the generation of voids in the bonded portions of the articles to be bonded to each other, and a bonding method using the same. Thus, the inventors have made the present invention.

### Means for solving the Problem

In order to accomplish the aforementioned and other objects, the inventors have diligently studied and found that it is possible to provide an inexpensive bonding material, which can be easily printed on articles to be bonded to each other and which can suppress the generation of voids in the bonded portions of the articles to be bonded to each other, and a bonding method using the same, if there is provided a bonding material of a copper paste comprising a copper powder having an average particle diameter of 0.1 to 1 *µ*m and an alcohol solvent, wherein the content of the copper powder is in the range of from 80 % by weight to 90 % by weight, and the content of the alcohol solvent is in the range of from 5 % by weight to 20 % by weight. Thus, the inventors have made the present invention.

According to the present invention, there is provided a bonding material of a copper paste comprising: a copper powder having an average particle diameter of 0.1 to 1 *µ*m; and an alcohol solvent, wherein the content of the copper powder is in the range of from 80 % by weight to 90 % by weight, and the content of the alcohol solvent is in the range of from 5 % by weight to 20 % by weight.

In this bonding material, the content of carbon in the copper powder is preferably 0.3 % by weight or less. According to the invention, the alcohol solvent is a monoalcohol, a diol or a terpene alcohol, and contains a triol. The bonding material preferably has a viscosity of not greater than 150 Pa · s when the viscosity of the bonding material is measured at 25 °C and 5 rpm by means of a rheometer. When the bonding material arranged between articles is heated to sinter copper therein to bond the articles to each other via a copper bonding layer, the percentage of an area occupied by voids with respect to the area of a bonded surface of the copper bonding layer is preferably 10 % or less, and the shear strength is preferably 6 MPa or more.

According to the present invention, there is provided a bonding method comprising the steps of: arranging the above-described bonding material between articles; and heating the bonding material to sinter copper therein to form a copper bonding layer to bond the articles to each other with the copper bonding layer. In this bonding method, the heating of the bonding material is preferably carried out while pressure is applied between the articles.

### Effects of the Invention

According to the present invention, it is possible to provide an inexpensive bonding material, which can be easily printed on articles to be bonded to each other and which can suppress the generation of voids in the bonded portions of the articles to be bonded to each other, and a bonding method using the same.

### Mode for Carrying Out the Invention

The preferred embodiment of a bonding material according to the present invention is made of a copper paste comprising: a copper powder having an average particle diameter of 0.1 to 1 *µ*m; and an alcohol solvent, wherein the content of the copper powder is in the range of from 80 % by weight to 90 % by weight, and the content of the alcohol solvent is in the range of from 5 % by weight to 20 % by weight.

The average particle diameter of the copper powder is in the range of from 0.1 *µ*m to 1 *µ*m, preferably in the range of from 0.2 *µ*m to 0.8 *µ*m, and more preferably in the range of from 0.3 *µ*m to 0.5 *µ*m. The copper powder is preferably a substantially spherical copper powder. The content of carbon in the copper powder is preferably 0.3 % by weight or less, and more preferably 0.1 % by weight or less.

As already mentioned, the alcohol solvent is a monoalcohol, a diol or a terpene alcohol, and contains a triol. The monoalcohol is preferably a decanol or a dodecanol, and may be 2-(2-hexyloxyethoxy) ethanol, 2-[2-(2-ethylhexyloxy) ethoxy] ethanol, 2-(2-butoxyethoxy) ethanol or the like. The diol is preferably hexanediol or octanediol. The terpene alcohol is preferably terpineol, and may be 2-(1-methyl-1-(4-methyl-3-cyclohexyl) ethoxy) ethanol, isobonyl cyclohexanol or the like. The triol is preferably a methyl-butanetriol or glycerin. Furthermore, these alcohol solvents may be mixed to be used.

The content of the copper powder (preferably containing 0.3 % by weight or less of carbon) in the copper paste is in the range of from 80 % by weight to 90 % by weight, and the content of the alcohol solvent therein is in the range of from 5 % by weight to 20 % by weight, the total of the content of the copper powder (preferably containing 0.3 % by weight or less of carbon) and the content of the alcohol solvent being preferably 100 % by weight. The copper paste is preferably in such a state that only the copper powder (preferably containing 0.3 % by weight or less of carbon) is dispersed in the alcohol solvent by mixing and kneading the copper powder and the alcohol solvent.

The viscosity of the bonding material is preferably 150 Pa · s or less and more preferably 100 Pa · s or less when it is measured at 25 °C and 5 rpm by means of a rheometer.

When the bonding material arranged between articles is heated (while applying pressure between the articles) to sinter copper therein to bond the articles to each other via a copper bonding layer, the percentage of an area occupied by voids with respect to the area of the bonded surface of the copper bonding layer is preferably 10 % or less (more preferably 5 % or less), and the shear strength (force applied on one of the articles when the one article is peeled off from the other article by pushing the one article in a lateral direction (a horizontal direction)) is preferably 6 MPa or more (more preferably 30 MPa or more).

In the preferred embodiment of a bonding method according to the present invention, the above-described bonding material is arranged between articles to be heated (preferably while applying pressure between the articles) to sinter copper therein to form a copper bonding layer to bond the articles to each other with the copper bonding layer.

Specifically, the above-described bonding material is applied on at least one of two articles to be arranged between the articles to be dried by being heated at temperature of preferably 60 to 150 °C (more preferably 80 to 130 °C) while applying a pressure of preferably 1 to 20 MPa (more preferably 5 to 10 MPa) between the articles in an inert atmosphere, such as a nitrogen atmosphere, and then, heated at a temperature of preferably 200 to 400 °C (more preferably 250 to 370 °C), to sinter copper in the copper paste to form a copper bonding layer to bond the articles with the copper bonding layer.

Throughout the specification, the expression "average particle diameter" means an average primary particle diameter calculated from a field emission-scanning electron microscope (FE-SEM). The average primary particle diameter of copper particles is calculated as follows. First, the copper particles are observed at a magnifying power of 20,000 by means of a field emission-scanning electron microscope (FE-SEM). Then, in a square measuring range wherein the total number of all copper particles having measurable major axes among the copper particles (primary particles) observed in a field of vision selected at random is about 200 to 500, the longest length of each of the copper particles is measured by means of an image analyzing particle size distribution measuring software (Mac-View Ver. 4 produced by Mountech Co., Ltd.). On the basis of the measured longest length of each of the copper particles, the average primary particle diameter is calculated as a 50 % particle diameter wherein the accumulated value in the number-size particle size distribution is 50 %.

### Examples

Examples of a bonding material and a bonding method using the same according to the present invention will be described below in detail.

### [Example 1 - Outside the scope of the current invention]

First, a mixed solution was prepared by mixing an aqueous copper nitrite solution, which was prepared by diluting 1174.6 g of a copper nitrite solution containing 50.2 % by weight of cupric nitrite trihydrate with 486.9 g of pure water, with an aqueous citric acid solution which was prepared by dissolving 92.3 g of citric acid hydrate in 687 g of pure water. There was also prepared an aqueous sodium hydroxide solution deaerated with nitrogen by feeding nitrogen at a flow rate of 4.0 L/min into a 5 L reaction vessel from the upper portion thereof after 449.1 g of an aqueous sodium hydroxide solution containing 48.7 % by weight of sodium hydroxide was mixed with 678 g of pure water to be put in the reaction vessel. Moreover, a hydrazine hydrate solution was prepared by dissolving 26.6 g of hydrazine hydrate (80 % hydrazine hydrate produced by Otsuka Chemical Co., Ltd.) in 687 g of pure water.

Then, the above-described aqueous sodium hydroxide solution was put in a 5 L beaker with stirrer to be held at a liquid temperature of 27 °C. While the solution was stirred at a rotation speed of 350 rpm, the above-described mixed solution was added thereto to form copper hydroxide. Thereafter, the above-described hydrazine hydrate solution was added thereto, and the temperature thereof was raised to 70 °C to be held for 2 hours to form cuprous oxide to prepare a cuprous oxide slurry.

After 113.9 g of hydrazine hydrate (80 % hydrazine hydrate produced by Otsuka Chemical Co., Ltd.) was added to the cuprous oxide slurry thus obtained, the temperature thereof was raised to 90 °C to obtain a copper powder slurry. After the solid-liquid separation of the copper powder slurry was carried out, a solid content thus obtained was sufficiently washed with pure water and dried at 110 °C for 9 hours in a nitrogen atmosphere to obtain a copper powder. The copper powder thus obtained was observed by means of a field emission-scanning electronic microscope (FE-SEM) (S-4700 produced by Hitachi Ltd.). As a result, the copper powder was a powder of substantially spherical particles. The average particle diameter thereof was calculated to be 0.5 *µ*m. The content of carbon in the copper powder was obtained by means of a carbon/sulfur analyzer (EMIA-220V produced by HORIBA, Ltd.). As a result, the content of carbon was 0.057 % by weight.

Then, 20.666 g (86.9 % by weight) of the copper powder thus obtained was mixed with 3.124 g (13.1 % by weight) of octanediol (2-ethyl-1,3-hexanediol produced by Wako Pure Chemical Industries, Ltd.) serving as a solvent. The mixture thus obtained was put in a disposable cup to be kneaded at a revolution speed of 1400 rpm and a rotation speed of 700 rpm for 30 seconds by means of a kneading and defoaming mixer (V-mini 300 produced by EME Co., Ltd.). After this kneading was carried out once again, the mixture was put in another disposable cup, and the same kneading was carried out twice to obtain a bonding material of a copper paste.

The dispersion state of the bonding material (copper paste) thus obtained was visually observed. As a result, there was no separation of liquid, so that the dispersion state thereof was good. The viscosity of the bonding material (copper paste) was obtained by means of a rheometer (viscoelasticity measuring apparatus) (HAAKE Rheostress 600 produced by Thermo Scientific, Inc., used cone: C35/2° ). As a result, the viscosity measured at 25 °C and 5 rpm was 42 (Pa · s), and the print quality (printability) of the bonding material was good.

Then, there were prepared three pure copper plates (of oxygen-free copper C1020) having a size of 10 mm x 10 mm x 2 mm treated with 10 % sulfuric acid after being degreased with industrial alcohol (SOLMIX AP7 produced by Japan Alcohol Trading Co., Ltd.), and three Si chips having a size of 3 mm x 3mm x 0.3 mm plated with silver.

Then, a metal mask having a thickness of 50 µm was arranged on each of the copper plates, and the above-described bonding material (copper paste) was applied on each of the copper plates so as to have a size of 4 mm x 4 mm and a thickness of 50 µm.

After each of the copper plates having the bonding material thus applied thereon was arranged in a bonding apparatus (a flip-chip bonder) (M90 DON-400 produced by HiSOL Inc.) to heat the bonding material at 100 °C in a nitrogen atmosphere to pre-dry the bonding material, it was cooled to 25 °C, and then, the Si chip was arranged on the bonding material. Then, while a load was applied between the bonding material and the Si chip, the temperature thereof was raised at a temperature rising rate of 10 °C/s from 25 °C to a firing temperature to be held for 5 minutes to fire the bonding material to sinter copper in the copper paste to form a copper bonding layer to bond the Si chip to the copper plate with the copper bonding layer to obtain a bonded product. Furthermore, the Si chips were bonded on the three copper plates on the first bonding conditions (on which the pre-drying period of time was 10 minutes, the load was 5 MPa, and the firing temperature was 350 °C), the second bonding conditions (on which the pre-drying period of time was 5 minutes, the load was 10 MPa, and the firing temperature was 300 °C), and the third bonding conditions (on which the pre-drying period of time was 5 minutes, the load was 10 MPa, and the firing temperature was 350 °C ), respectively.

With respect to the each of bonded products thus obtained, voids having a diameter of not less than 0.1 mm on the bonded surface were observed at 50 MHz by means of a high-precision ultrasonic microscope (C-SAM) (D9500 produced by SONOSCAN, INC.), and a void fraction on the bonded surface (the percentage of an area occupied by voids with respect to the area of the bonded surface) was calculated. As a result, with respect to each of the bonded products, the void fraction was a low value of 0 %, and it was good. The shear strength (force applied on the Si chip when the Si chip was peeled off from the copper plate by pushing the Si chip in a lateral direction (a horizontal direction)) of the bonded product was measured at a shear height of 50 *µ*m and a test speed of 5 mm/min by means of a bonding strength tester (bond tester) (Series 4000 produced by DAGE Corporation). As a result, the shear strength was a high value of 84 MPa, 9 MPa and 100 MPa, respectively, and they were good.

### [Example 2 - Outside the scope of the current invention]

First, a mixed solution deaerated with nitrogen was prepared by feeding nitrogen at a flow rate of 4.0 L/min into a 5 L reaction vessel from the upper portion thereof after an aqueous copper nitrite solution, which was prepared by diluting 1412.3 g of a copper nitrite solution containing 50.1 % by weight of cupric nitrite trihydrate with 249.2 g of pure water, was mixed with an aqueous citric acid solution, which was prepared by dissolving 110.8 g of citric acid hydrate in 684.3 g of pure water, to be put in the reaction vessel. Also, an aqueous sodium hydroxide solution was prepared by mixing 538 g of an aqueous sodium hydroxide solution containing 48.8 % by weight of sodium hydroxide with 589 g of pure water. Moreover, a hydrazine hydrate solution was prepared by dissolving 31.9 g of hydrazine hydrate (80 % hydrazine hydrate produced by Otsuka Chemical Co., Ltd.) in 684.3 g of pure water.

Then, the above-described aqueous copper nitrite solution was put in a 5 L beaker with stirrer to be held at a liquid temperature of 27 °C. While the solution was stirred at a rotation speed of 350 rpm, the above-described aqueous sodium hydroxide solution was added thereto to form copper hydroxide, and the temperature thereof was raised to 35 °C . Thereafter, the above-described hydrazine hydrate solution was added thereto, and the temperature thereof was raised to 50 °C to be held for 2 hours to form cuprous oxide to prepare a cuprous oxide slurry.

After 136.9 g of hydrazine hydrate (80 % hydrazine hydrate produced by Otsuka Chemical Co., Ltd.) was added to the cuprous oxide slurry, the temperature thereof was raised to 90 °C to obtain a copper powder slurry. After the solid-liquid separation of the copper powder slurry was carried out, a solid content thus obtained was sufficiently washed with pure water and dried at 110 °C for 9 hours in a nitrogen atmosphere to obtain a copper powder. The copper powder thus obtained was observed by the same method as that in Example 1. As a result, the copper powder was a powder of substantially spherical particles. The average particle diameter thereof was calculated to be 0.4 *µ*m. The content of carbon in the copper powder was obtained by the same method as that in Example 1. As a result, the content of carbon was 0.028 % by weight.

Then, a bonding material of a copper paste was obtained by the same method as that in Example 1, except that there was used a mixture obtained by mixing 19.9968 g (86.4 % by weight) of the obtained copper powder with 3.1368 g (13.6 % by weight) of octanediol (2-ethyl-1,3-hexanediol produced by Wako Pure Chemical Industries, Ltd.) serving as a solvent.

The dispersion state of the bonding material (copper paste) thus obtained was observed by the same method as that in Example 1. As a result, the dispersion state thereof was good. The viscosity of the bonding material was obtained by the same method as that in Example 1. As a result, the viscosity measured at 25 °C and 5 rpm was 37 (Pa · s), and the print quality (printability) of the bonding material was good.

With respect to each of bonded products obtained by the same method as that in Example 1 using the bonding material thus obtained, the void fraction on the bonded surface and the shear strength were measured by the same methods as those in Example 1. As a result, the void fraction was a low value of 0 %, and the shear strength was a high value of 87 MPa, 23 MPa and 22 MPa, respectively, and they were good.

### [Example 3 - Outside the scope of the current invention]

First, after 3800 g of pure water was put in a 5 L reaction vessel, air was fed at a flow rate of 0.5 L/min into the reaction vessel from the lower portion thereof, and the stirring rod was rotated in the reaction vessel. Then, 5.33 g of citric acid hydrate (produced by Fuso Chemical Co., Ltd.) serving as a complexing agent was put in the reaction vessel, and 43.17 g of cuprous oxide (NC-301 produced by Nissin Chemco Ltd., average particle diameter = 2.5 *µ*m) was put in the reaction vessel to allow a reaction at 30 °C for 2 hours to carry out a complexing treatment. Thereafter, the supply of air was stopped, and nitrogen was fed at a flow rate of 2.0 L/min into the reaction vessel from the upper portion thereof. Then, the temperature thereof was raised to 90 °C, and 40.2 g of hydrazine hydrate (80 % hydrazine hydrate produced by Otsuka Chemical Co., Ltd.) serving as a reducing agent was put in the reaction vessel to allow a reduction reaction to be held for 1 hour. Then, the stirring was stopped, and a solid content obtained by the reaction was washed and dried to obtain a copper powder. The copper powder thus obtained was observed by the same method as that in Example 1. As a result, the copper powder was a powder of substantially spherical particles. The average particle diameter thereof was calculated to be 0.2 *µ*m. The content of carbon in the copper powder was obtained by the same method as that in Example 1. As a result, the content of carbon was 0.183 % by weight.

Then, a bonding material of a copper paste was obtained by the same method as that in Example 1, except that there was used a mixture obtained by mixing 20.0471 g (87.0 % by weight) of the obtained copper powder with 3.0047 g (13.0 % by weight) of octanediol (2-ethyl-1,3-hexanediol produced by Wako Pure Chemical Industries, Ltd.) serving as a solvent.

The dispersion state of the bonding material (copper paste) thus obtained was observed by the same method as that in Example 1. As a result, the dispersion state thereof was nearly good although the bonding material was slightly aggregated. The viscosity of the bonding material was obtained by the same method as that in Example 1. As a result, the viscosity measured at 25 °C and 5 rpm was 18 (Pa · s), and the print quality (printability) of the bonding material was good.

With respect to a bonded product obtained (on the first bonding conditions) by the same method as that in Example 1 using the bonding material thus obtained, the void fraction on the bonded surface and the shear strength were measured by the same methods as those in Example 1. As a result, the void fraction was a low value of 3 %, and the shear strength was a high value of 38 MPa, so that they were good.

### [Comparative Example 1]

A copper powder coated with a gelatin was obtained by the same method as that in Example 2, except that 35.1 g of a collagen peptide (collagen peptide 800F produced by Nitta Gelatin Inc.) serving as the gelatin was added when hydrazine hydrate was added to the cuprous oxide slurry. The copper powder (coated with the gelatin) thus obtained was observed by the same method as that in Example 1. As a result, the copper powder was a powder of substantially spherical particles. The average particle diameter thereof was calculated to be 0.3 *µ*m. The content of carbon in the copper powder was obtained by the same method as that in Example 1. As a result, the content of carbon was 0.347 % by weight.

Then, a bonding material of a copper paste was obtained (on the first bonding conditions) by the same method as that in Example 1, except that there was used a mixture obtained by mixing 20.2517 g (86.4 % by weight) of the obtained copper powder (coated with the gelatin) with 3.1805 g (13.6 % by weight) of octanediol (2-ethyl-1,3-hexanediol produced by Wako Pure Chemical Industries, Ltd.) serving as a solvent.

The dispersion state of the bonding material (copper paste) thus obtained was observed by the same method as that in Example 1. As a result, the dispersion state thereof was nearly good although it was slightly plasmon. The viscosity of the bonding material was obtained by the same method as that in Example 1. As a result, the viscosity measured at 25 °C and 5 rpm was 59 (Pa · s), and the print quality (printability) of the bonding material was nearly good.

The bonding material thus obtained was used for attempting to produce a bonded product (on each of the first and third bonding conditions) by the same method as that in Example 1. However, it was not possible to bond the Si chip to the copper plate on each of the first and third bonding conditions. The bonding material thus obtained was also used for attempting to produce a bonded product by the same method as that in Example 1, except that the load was increased to 10 MPa. However, it was not possible to bond the Si chip to the copper plate.

### [Example 4 - Outside the scope of the current invention]

First, an aqueous copper sulfate solution was prepared by dissolving 2.240 kg of copper sulfate pentahydrate (CuSO₄ · 5H₂O) in 5.353 kg of pure water, and an aqueous alkali solution was prepared by diluting 1.840 kg of an aqueous sodium hydroxide solution containing 48.4 % by weight of sodium hydroxide with 6.800 kg of pure water.

After the above-described aqueous copper sulfate solution having a temperature of 27.3 °C was added to the above-described aqueous alkali solution held at 27.6 °C to be strongly stirred, the liquid temperature thereof was raised to 36.0 °C to be held to obtain a copper hydroxide suspension containing copper hydroxide deposited in the liquid. Furthermore, the equivalent ratio of sodium hydroxide to copper in the liquid was 1.24 when the above-described aqueous alkali solution was added to the above-described aqueous copper sulfate solution.

Then, an aqueous glucose solution prepared by dissolving 2.419 kg of glucose in 3.433 kg of pure water was added to the above-described copper hydroxide suspension in a nitrogen atmosphere. After the liquid temperature thereof was raised to 70.6 °C in 30 minutes, it was held for 30 minutes.

After air was fed into the copper hydroxide suspension at a flow rate of 2.26 L/min to carry out the bubbling thereof for 200 minutes, it was allowed to stand for one day in a nitrogen atmosphere. Thereafter, a supematant liquid thus obtained was removed to collect nearly the entire amount of precipitate, and 2.32 kg of pure water was added to this precipitate to obtain 4.80 kg of a cuprous oxide suspension.

While the cuprous oxide suspension thus obtained was put in a reaction vessel to be stirred, the temperature thereof was held at 45.0 °C, and 1.25 equivalent (1.25 times as large as stoichiometry required to entirely reduce cuprous oxide) of hydrazine hydrate (80.5 % hydrazine hydrate) was added thereto. Thereafter, the temperature of the suspension was raised to 50.0 °C in 30 minutes, and further raised to 85.0 °C in 70 minutes to be held. Then, 0.600 equivalent of hydrazine hydrate (80.5 % hydrazine hydrate) was dividedly added thereto in 30 minutes to entirely reduce cuprous oxide to copper to obtain a copper powder slurry. After the solid-liquid separation of the copper powder slurry was carried out, a solid content thus obtained was sufficiently washed with pure water and dried at 110 °C for 9 hours in a nitrogen atmosphere to obtain a copper powder. The copper powder thus obtained was observed by means of a field emission-scanning electronic microscope (FE-SEM) (S-4700 produced by Hitachi Ltd.). As a result, the copper powder was a powder of substantially spherical particles. The average particle diameter thereof was calculated to be 1.0 *µ*m. The content of carbon in the copper powder was obtained by means of a carbon/sulfur analyzer (EMIA-220V produced by HORIBA, Ltd.). As a result, the content of carbon was 0.019 % by weight.

Then, a bonding material of a copper paste was obtained by the same method as that in Example 1, except that there was used a mixture obtained by mixing 13.1 g (87.0 % by weight) of the copper powder thus obtained with 2.0 g (13.0 % by weight) of octanediol (2-ethyl-1,3-hexanediol produced by Wako Pure Chemical Industries, Ltd.).

The dispersion state of the bonding material (copper paste) thus obtained was observed by the same method as that in Example 1. As a result, the dispersion state thereof was good. The viscosity of the bonding material was obtained by the same method as that in Example 1. As a result, the viscosity measured at 25 °C and 5 rpm was 32 (Pa · s), and the print quality (printability) of the bonding material was good.

With respect to a bonded product obtained (on the first bonding conditions) by the same method as that in Example 1 using the bonding material thus obtained, the void fraction on the bonded surface and the shear strength were measured by the same methods as those in Example 1. As a result, the void fraction was a low value of 0 %, and the shear strength was a high value of 14.6 MPa, so that they were good.

### [Comparative Example 2]

First, an aqueous copper sulfate solution was prepared by dissolving 2.240 kg of copper sulfate pentahydrate (CuSO₄ · 5H₂O) in 5.353 kg of pure water, and an aqueous alkali solution was prepared by diluting 1.840 kg of an aqueous sodium hydroxide solution containing 48.4 % by weight of sodium hydroxide with 6.800 kg of pure water.

After the above-described aqueous copper sulfate solution having a temperature of 27.3 °C was added to the above-described aqueous alkali solution held at 27.6 °C to be strongly stirred, the liquid temperature thereof was raised to 36.0 °C to be held to obtain a copper hydroxide suspension containing copper hydroxide deposited in the liquid. Furthermore, the equivalent ratio of sodium hydroxide to copper in the liquid was 1.24 when the above-described aqueous alkali solution was added to the above-described aqueous copper sulfate solution.

Then, an aqueous glucose solution prepared by dissolving 2.419 kg of glucose in 3.433 kg of pure water was added to the above-described copper hydroxide suspension in a nitrogen atmosphere. After the liquid temperature thereof was raised to 70.6 °C in 30 minutes, it was held for 30 minutes.

After air was fed into the copper hydroxide suspension at a flow rate of 2.26 L/min to carry out the bubbling thereof for 200 minutes, it was allowed to stand for one day in a nitrogen atmosphere. Thereafter, the supematant liquid was removed to collect nearly the entire amount of precipitate, and 2.32 kg of pure water was added to this precipitate to obtain 4.80 kg of a cuprous oxide suspension.

While the cuprous oxide suspension thus obtained was put in a reaction vessel to be stirred, the temperature thereof was held at 45.0 °C, and 0.223 equivalent (0.223 times as large as stoichiometry required to entirely reduce cuprous oxide) of hydrazine hydrate (80.5 % hydrazine hydrate) was added thereto. Thereafter, the temperature of the suspension was raised to 49.1 °C in 30 minutes, and 0.668 equivalent of hydrazine hydrate (80.5 % hydrazine hydrate) was dividedly added thereto in 120 minutes. Thereafter, the temperature thereof was raised to 84.1 °C in 140 minutes to be held, and 1.055 equivalent of hydrazine hydrate (80.5 % hydrazine hydrate) was dividedly added thereto in 150 minutes to entirely reduce cuprous oxide to copper to obtain a copper powder slurry. After the solid-liquid separation of the copper powder slurry was carried out, a solid content thus obtained was sufficiently washed with pure water and dried at 110 °C for 9 hours in a nitrogen atmosphere to obtain a copper powder. The copper powder thus obtained was observed by means of a field emission-scanning electronic microscope (FE-SEM) (S-4700 produced by Hitachi Ltd.). As a result, the copper powder was a powder of substantially spherical particles. The average particle diameter thereof was calculated to be 3.0 *µ*m. The content of carbon in the copper powder was obtained by means of a carbon/sulfur analyzer (EMIA-220V produced by HORIBA, Ltd.). As a result, the content of carbon was 0.051 % by weight.

Then, a bonding material of a copper paste was obtained by the same method as that in Example 1, except that there was used a mixture obtained by mixing 13.1 g (87.0 % by weight) of the copper powder thus obtained with 2.0 g (13.0 % by weight) of octanediol (2-ethyl-1,3-hexanediol produced by Wako Pure Chemical Industries, Ltd.).

The dispersion state of the bonding material (copper paste) thus obtained was observed by the same method as that in Example 1. As a result, the dispersion state thereof was good. The viscosity of the bonding material was obtained by the same method as that in Example 1. As a result, the viscosity measured at 25 °C and 5 rpm was 5.7 (Pa · s), and the print quality (printability) of the bonding material was good.

With respect to a bonded product obtained (on the second bonding conditions) by the same method as that in Example 1 using the bonding material thus obtained, the void fraction on the bonded surface and the shear strength were measured by the same methods as those in Example 1. As a result, the void fraction was a high value of 20 %, and the shear strength was a low value of 4.2 MPa, so that they were not good.

### [Example 5 - Outside the scope of the current invention]

A bonding material of a copper paste was obtained by the same method as that in Example 1, except that there was used a mixture obtained by mixing 13.1 g (87.0 % by weight) of the copper powder obtained in Example 2 with 2.0 g (13.0 % by weight) of 1-decanol (produced by Wako Pure Chemical Industries, Ltd.) serving as a solvent.

The dispersion state of the bonding material (copper paste) thus obtained was observed by the same method as that in Example 1. As a result, the dispersion state thereof was good. The viscosity of the bonding material was obtained by the same method as that in Example 1. As a result, the viscosity measured at 25 °C and 5 rpm was 7.6 (Pa · s), and the print quality (printability) of the bonding material was good.

With respect to a bonded product obtained (on the second bonding conditions) by the same method as that in Example 1 using the bonding material thus obtained, the void fraction on the bonded surface and the shear strength were measured by the same methods as those in Example 1. As a result, the void fraction was a low value of 0 %, and the shear strength was a high value of 12.2 MPa, so that they were good.

### [Example 6 - Outside the scope of the current invention]

A bonding material of a copper paste was obtained by the same method as that in Example 1, except that there was used a mixture obtained by mixing 13.1 g (87.0 % by weight) of the copper powder obtained in Example 2 with 2.0 g (13.0 % by weight) of 1-dodecanol (produced by Tokyo Chemical Industry Co., Ltd.) serving as a solvent.

The dispersion state of the bonding material (copper paste) thus obtained was observed by the same method as that in Example 1. As a result, the dispersion state thereof was good. The viscosity of the bonding material was obtained by the same method as that in Example 1. As a result, the viscosity measured at 25 °C and 5 rpm was 16.8 (Pa · s), and the print quality (printability) of the bonding material was good.

With respect to a bonded product obtained (on the second bonding conditions) by the same method as that in Example 1 using the bonding material thus obtained, the void fraction on the bonded surface and the shear strength were measured by the same methods as those in Example 1. As a result, the void fraction was a low value of 0 %, and the shear strength was a high value of 14.7 MPa, so that they were good.

### [Example 7]

A bonding material of a copper paste was obtained by the same method as that in Example 1, except that there was used a mixture obtained by mixing 13.1 g (87.0 % by weight) of the copper powder obtained in Example 2 with 1.0 g (6.5 % by weight) of octanediol (2-ethyl-1,3-hexanediol produced by Wako Pure Chemical Industries, Ltd.) and 1.0 g (6.5 % by weight) of 2-methylbutane-1,2,4-triol (IPLT-B produced by Nippon Terpene Chemicals, Inc.) serving as solvents.

The dispersion state of the bonding material (copper paste) thus obtained was observed by the same method as that in Example 1. As a result, the dispersion state thereof was good. The viscosity of the bonding material was obtained by the same method as that in Example 1. As a result, the viscosity measured at 25 °C and 5 rpm was 96.4 (Pa · s), and the print quality (printability) of the bonding material was good.

With respect to a bonded product obtained (on the second bonding conditions) by the same method as that in Example 1 using the bonding material thus obtained, the void fraction on the bonded surface and the shear strength were measured by the same methods as those in Example 1. As a result, the void fraction was a low value of 0 %, and the shear strength was a high value of 11.6 MPa, so that they were good.

### [Example 8 - Outside the scope of the current invention]

A bonding material of a copper paste was obtained by the same method as that in Example 1, except that there was used a mixture obtained by mixing 13.1 g (87.0 % by weight) of the copper powder obtained in Example 2 with 2.0 g (13.0 % by weight) of 2,5-hexanediol (produced by Tokyo Chemical Industry Co., Ltd.) serving as a solvent.

The dispersion state of the bonding material (copper paste) thus obtained was observed by the same method as that in Example 1. As a result, the dispersion state thereof was good. The viscosity of the bonding material was obtained by the same method as that in Example 1. As a result, the viscosity measured at 25 °C and 5 rpm was 16.8 (Pa · s), and the print quality (printability) of the bonding material was good.

With respect to a bonded product obtained (on the second bonding conditions) by the same method as that in Example 1 using the bonding material thus obtained, the void fraction on the bonded surface and the shear strength were measured by the same methods as those in Example 1. As a result, the void fraction was a low value of 0 %, and the shear strength was a high value of 12.2 MPa, so that they were good.

### [Example 9 - Outside the scope of the current invention]

A bonding material of a copper paste was obtained by the same method as that in Example 1, except that there was used a mixture obtained by mixing 13.1 g (87.0 % by weight) of the copper powder obtained in Example 2 with 2.0 g (13.0 % by weight) of 2-(2-hexyloxy) ethoxy) ethanol (hexyl diglycol produced by Nippon Nyukazai Co., Ltd.) serving as a solvent.

The dispersion state of the bonding material (copper paste) thus obtained was observed by the same method as that in Example 1. As a result, the dispersion state thereof was good. The viscosity of the bonding material was obtained by the same method as that in Example 1. As a result, the viscosity measured at 25 °C and 5 rpm was 10.1 (Pa · s), and the print quality (printability) of the bonding material was good.

With respect to a bonded product obtained (on the second bonding conditions) by the same method as that in Example 1 using the bonding material thus obtained, the void fraction on the bonded surface and the shear strength were measured by the same methods as those in Example 1. As a result, the void fraction was a low value of 0 %, and the shear strength was a high value of 19.0 MPa, so that they were good.

### [Example 10 - Outside the scope of the current invention]

A bonding material of a copper paste was obtained by the same method as that in Example 1, except that there was used a mixture obtained by mixing 13.1 g (87.0 % by weight) of the copper powder obtained in Example 2 with 2.0 g (13.0 % by weight) of 2-(1-methyl-1-(4-methyl-3-cyclohexyl) ethoxy ethanol (TOE-100 produced by Nippon Terpene Chemicals, Inc.) serving as a solvent.

The dispersion state of the bonding material (copper paste) thus obtained was observed by the same method as that in Example 1. As a result, the dispersion state thereof was good. The viscosity of the bonding material was obtained by the same method as that in Example 1. As a result, the viscosity measured at 25 °C and 5 rpm was 46.0 (Pa · s), and the print quality (printability) of the bonding material was good.

With respect to a bonded product obtained (on the second bonding conditions) by the same method as that in Example 1 using the bonding material thus obtained, the void fraction on the bonded surface and the shear strength were measured by the same methods as those in Example 1. As a result, the void fraction was a low value of 0 %, and the shear strength was a high value of 13.3 MPa, so that they were good.

### [Example 11 - Outside the scope of the current invention]

A bonding material of a copper paste was obtained by the same method as that in Example 1, except that there was used a mixture obtained by mixing 13.1 g (87.0 % by weight) of the copper powder obtained in Example 2 with 2.0 g (13.0 % by weight) of terpineol (produced by Wako Pure Chemical Industries, Ltd.) serving as a solvent.

The dispersion state of the bonding material (copper paste) thus obtained was observed by the same method as that in Example 1. As a result, the dispersion state thereof was good. The viscosity of the bonding material was obtained by the same method as that in Example 1. As a result, the viscosity measured at 25 °C and 5 rpm was 41.6 (Pa · s), and the print quality (printability) of the bonding material was good.

With respect to a bonded product obtained (on the second bonding conditions) by the same method as that in Example 1 using the bonding material thus obtained, the void fraction on the bonded surface and the shear strength were measured by the same methods as those in Example 1. As a result, the void fraction was a low value of 0 %, and the shear strength was a high value of 25.8 MPa, so that they were good.

### [Example 12 - Outside the scope of the current invention]

A bonding material of a copper paste was obtained by the same method as that in Example 1, except that there was used a mixture obtained by mixing 12.0 g (80.0 % by weight) of the copper powder obtained in Example 2 with 3.0 g (20.0 % by weight) of octanediol (2-ethyl-1,3-hexanediol produced by Wako Pure Chemical Industries, Ltd.) serving as a solvent.

The dispersion state of the bonding material (copper paste) thus obtained was observed by the same method as that in Example 1. As a result, the dispersion state thereof was good. The viscosity of the bonding material was obtained by the same method as that in Example 1. As a result, the viscosity measured at 25 °C and 5 rpm was 4.6 (Pa · s), and the print quality (printability) of the bonding material was good.

With respect to a bonded product obtained (on the second bonding conditions) by the same method as that in Example 1 using the bonding material thus obtained, the void fraction on the bonded surface and the shear strength were measured by the same methods as those in Example 1. As a result, the void fraction was a low value of 0 %, and the shear strength was a high value of 22.0 MPa, so that they were good.

### [Comparative Example 3]

It was attempted to obtain a bonding material of a copper paste by the same method as that in Example 1, except that there was used a mixture obtained by mixing 13.1 g (87.0 % by weight) of the copper powder obtained in Example 2 with 2.0 g (13.0 % by weight) of dibutyl diglycol (produced by Nippon Nyukazai Co., Ltd.) serving as a glycol ester solvent. However, it was not possible to obtain any paste.

### [Comparative Example 4]

It was attempted to obtain a bonding material of a copper paste by the same method as that in Example 1, except that there was used a mixture obtained by mixing 13.1 g (87.0 % by weight) of the copper powder obtained in Example 2 with 2.0 g (13.0 % by weight) of tetradecane (produced by Tokyo Chemical Industry Co., Ltd.) serving as a hydrocarbon solvent. However, it was not possible to obtain any paste.

### [Comparative Example 5]

It was attempted to obtain a bonding material of a copper paste by the same method as that in Example 1, except that there was used a mixture obtained by mixing 13.1 g (87.0 % by weight) of the copper powder obtained in Example 2 with 2.0 g (13.0 % by weight) of butyl carbitol acetate (produced by Wako Pure Chemical Industries, Ltd.) serving as a glycol ester solvent. However, it was not possible to obtain any paste.

## Claims

1. A bonding material of a copper paste comprising:
a copper powder having an average particle diameter of 0.1 to 1 *µ*m; and
an alcohol solvent which is a monoalcohol, a diol or a terpene alcohol and which contains a triol,
wherein the content of the copper powder is in the range of from 80 % by weight to 90 % by weight, and the content of the alcohol solvent is in the range of from 5 % by weight to 20 % by weight, and
wherein the average particle diameter is an average primary particle diameter calculated from a field emission-scanning electron microscope (FE-SEM), the average primary particle diameter being calculated as a 50 % particle diameter wherein the accumulated value in the number-size particle size distribution is 50 %, on the basis of the longest length of each of the copper particles, the longest length of each of the copper particles being measured by means of an image analyzing particle size distribution measuring software, in a square measuring range wherein the total number of all the copper particles having measurable major axes among the copper particles (primary particles) observed in a field of vision selected at random is about 200 to 500, when the copper particles are observed at a magnifying power of 20,000 by means of the field emission-scanning electron microscope (FE-SEM) .

2. A bonding material as set forth in claim 1, wherein the content of carbon in said copper powder is not larger than 0.3 % by weight.

3. A bonding material as set forth in claim 1 or 2, which has a viscosity of not greater than 150 Pa · s when the viscosity of said bonding material is measured at 25 °C and 5 rpm by means of a rheometer.

4. A bonding method comprising the steps of:
arranging a bonding material, as set forth in any one of claims 1 through 3, between articles; and
heating the bonding material to sinter copper therein to form a copper bonding layer to bond said articles to each other with the copper bonding layer.

5. A bonding method as set forth in claim 4, wherein said heating is carried out while pressure is applied between said articles.

6. A bonding method as set forth in claim 4 or 5, wherein the percentage of an area occupied by voids with respect to the area of a bonded surface of said copper bonding layer is not larger than 10 %.

7. A bonding method as set forth in any one of claims 4 through 6, wherein the shear strength is not less than 6 MPa between said articles.

## Patentansprüche

1. Bindematerial für eine Kupferpaste, umfassend:
ein Kupferpulver mit einem durchschnittlichen Partikeldurchmesser von 0,1 bis 1 µm; und
ein alkoholisches Lösungsmittel, das ein Monoalkohol, ein Diol oder ein Terpenalkohol ist und ein Triol enthält,
wobei der Gehalt des Kupferpulvers im Bereich von 80 Gew.-% bis 90 Gew.-% liegt und der Gehalt des alkoholischen Lösungsmittels im Bereich von 5 Gew.-% bis 20 Gew.-% liegt, und
wobei der durchschnittliche Partikeldurchmesser ein durchschnittlicher Primärpartikeldurchmesser ist, der von einem Feldemissions-Rasterelektronenmikroskop (FE-SEM) berechnet wird, wobei der durchschnittliche Primärpartikeldurchmesser als ein 50 %-Partikeldurchmesser, bei dem der ackumulierte Wert in der Partikelgrößenverteilung in Bezug auf Anzahl und
Größe 50 % beträgt, auf der Basis der längsten Länge jedes der Kupferpartikel berechnet wird, wobei die längste Länge jedes der Kupferpartikel mittels einer Messsoftware für die Partikelgrößenverteilung mittels Bildanalyse in einem quadratischen Messbereich gemessen wird, wobei die Gesamtzahl aller Kupferpartikel mit messbaren Hauptachsen unter den Kupferpartikeln (Primärpartikel), die in einem zufällig ausgewählten Sichtfeld beobachtet werden, etwa 200 bis 500 beträgt, wenn die Kupferpartikel bei einer Vergrößerungsleistung von 20.000 mittels des Feldemissions-Rasterelektronenmikroskops (FE-SEM) beobachtet werden.

2. Bindematerial nach Anspruch 1, wobei der Kohlenstoffgehalt in dem Kupferpulver nicht mehr als 0,3 Gew.-% beträgt.

3. Bindematerial nach einem der Ansprüche 1 oder 2, das eine Viskosität von nicht mehr als 150 Pa·s aufweist, wenn die Viskosität des Bindematerials bei 25°C und 5 U/min mit einem Rheometer gemessen wird.

4. Bindeverfahren, umfassend die Schritte:
Anordnen eines Bindematerials nach einem der Ansprüche 1 bis 3 zwischen Gegenständen; und
Erhitzen des Bindematerials, um darin Kupfer zu sintern und eine Kupferbindungsschicht zu bilden, um die Gegenstände mit der Kupferbindungsschicht aneinander zu binden.

5. Bindeverfahren nach Anspruch 4, wobei die Erwärmung durchgeführt wird, während Druck zwischen den Gegenständen ausgeübt wird.

6. Bindeverfahren nach einem der Ansprüche 4 oder 5, wobei der prozentuale Anteil einer von Hohlräumen eingenommenen Fläche in Bezug auf die Fläche einer gebundenen Oberfläche der Kupferbindeschicht nicht größer als 10 % ist.

7. Bindeverfahren nach einem der Ansprüche 4 bis 6, wobei die Scherfestigkeit zwischen den Gegenständen nicht weniger als 6 MPa beträgt.

## Revendications

1. Matériau de liaison en pâte de cuivre comprenant :
une poudre de cuivre ayant un diamètre particulaire moyen de 0,1 à 1 µm ; et
un solvant à base d'alcool qui est un monoalcool, un diol ou un alcool terpène et qui contient un triol,
dans lequel la teneur de la poudre de cuivre est dans la plage allant de 80 % en poids à 90 % en poids, et la teneur du solvant à base d'alcool est dans la plage allant de 5 % en poids à 20 % en poids, et
dans lequel le diamètre particulaire moyen est un diamètre particulaire primaire moyen calculé à partir d'un microscope électronique à balayage à émission par effet de champ (FE-SEM), le diamètre particulaire primaire moyen étant calculé comme un diamètre particulaire de 50 %, dans lequel la valeur accumulée dans la distribution granulométrique des particules est de 50 %, sur la base de la longueur la plus longue de chacune des particules de cuivre, la longueur la plus longue de chacune des particules de cuivre étant mesurée au moyen d'un logiciel de mesurage de distribution granulométrique d'analyse d'image, dans une plage de mesure carrée, dans lequel le nombre total de toutes les particules de cuivre ayant des axes principaux mesurables parmi les particules de cuivre (particules primaires) observées dans un champ de vision sélectionné de manière aléatoire est d'environ 200 à 500, dans lequel les particules de cuivre sont observées à un pouvoir grossissant de 20 000 au moyen du microscope électronique à balayage à émission par effet de champ (FE-SEM).

2. Matériau de liaison selon la revendication 1, dans lequel la teneur en carbone de ladite poudre de cuivre n'est pas supérieure à 0,3 % en poids.

3. Matériau de liaison selon la revendication 1 ou 2, qui a une viscosité n'étant pas supérieure à 125 Pa·s quand la viscosité dudit matériau de liaison est mesurée à 25 °C et à 5 tr/min au moyen d'un rhéomètre.

4. Procédé de liaison comprenant les étapes consistant à :
agencer un matériau de liaison selon l'une quelconque des revendications 1 à 3 entre des articles ; et
chauffer le matériau de liaison pour fritter le cuivre à l'intérieur de celui-ci afin de former une couche de liaison de cuivre pour lier lesdits articles les uns aux autres avec la couche de liaison de cuivre.

5. Procédé de liaison selon la revendication 4, dans lequel ladite étape de chauffe est exécutée tout en appliquant une pression entre lesdits articles.

6. Procédé de liaison selon la revendication 4 ou 5, dans lequel le pourcentage d'une aire occupée des vides par rapport à l'aire d'une surface liée de ladite couche de liaison de cuivre n'est pas supérieur à 10 %.

7. Procédé de liaison selon l'une quelconque des revendications 4 à 6, dans lequel la résistance au cisaillement n'est pas inférieure à 6 MPa entre lesdits articles.
